(19) Europäisches Patentamt
European Patent Office
Office européen des brevets

(11) **EP 2 261 884 B1**

(12) **EUROPEAN PATENT SPECIFICATION**

(45) Date of publication and mention
of the grant of the patent:
**17.08.2011  Bulletin 2011/33**

(51) Int Cl.:
**G09G 3/32** (2006.01)

(21) Application number: **10158802.8**

(22) Date of filing: **31.03.2010**

(54) **Pixel of an OLED display and the corresponding display**

Pixel einer OLED Anzeige und entsprechende Anzeige

Pixel d'un affichage OLED et affichage correspondant

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **05.06.2009  KR 20090049848**

(43) Date of publication of application:
**15.12.2010  Bulletin 2010/50**

(73) Proprietor: **Samsung Mobile Display Co., Ltd.
Yongin-City
Gyunggi-do (KR)**

(72) Inventors:
• **Kang, Chul-Kyu
Gyunggi-Do 446-711 (KR)**

• **Choi, Sang-Moo
Gyunggi-Do 446-711 (KR)**
• **Kim, Keum-Nam
Gyunggi-Do 446-711 (KR)**

(74) Representative: **Gulde Hengelhaupt Ziebig & Schneider
Patentanwälte - Rechtsanwälte
Wallstrasse 58/59
10179 Berlin (DE)**

(56) References cited:
**EP-A1- 2 128 848       WO-A1-2006/103797
US-A1- 2004 257 353    US-A1- 2007 132 694**

**Description**

**BACKGROUND**

**1. Field**

The following description relates to a pixel and an organic light emitting display using the same.

**2. Description of the Related Art**

Recently, various flat panel displays (FPDs) having reduced weight and volume as compared to cathode ray tubes (CRTs) have been developed. The FPDs include liquid crystal displays (LCDs), field emission displays (FEDs), plasma display panels (PDPs), and organic light emitting displays.

Among the FPDs, the organic light emitting displays display images using organic light emitting diodes (OLEDs) that generate light through the re-combination of electrons and holes. The organic light emitting display has fast response times and is driven with low power consumption.

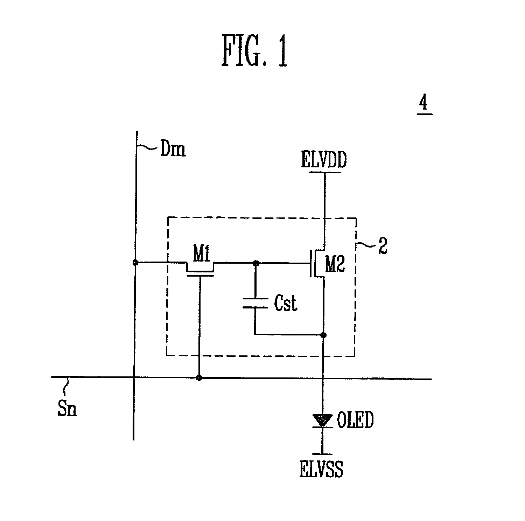

FIG. 1 is a circuit diagram illustrating a pixel of a conventional organic light emitting display. In FIG. 1, transistors included in the pixel are NMOS transistors.

Referring to FIG. 1, a pixel 4 of the conventional organic light emitting display includes an organic light emitting diode (OLED), and a pixel circuit 2 coupled to a data line Dm and a scan line Sn to control the OLED.

The anode electrode of the OLED is coupled to the pixel circuit 2 and the cathode electrode of the OLED is coupled to a second power source ELVSS. The OLED generates light with a predetermined brightness corresponding to current supplied from the pixel circuit 2.

The pixel circuit 2 controls an amount of current supplied to the OLED corresponding to a data signal supplied to the data line Dm when a scan signal is supplied to the scan line Sn. Therefore, the pixel circuit 2 includes a second transistor M2 (that is, a driving transistor) coupled between a first power source ELVDD and the OLED, a first transistor M1 coupled between the second transistor M2 and the data line Dm, and having a gate electrode coupled to the scan line Sn, and a storage capacitor Cst coupled between a gate electrode and a second electrode of the second transistor M2.

The gate electrode of the first transistor M1 is coupled to the scan line Sn, and the first electrode thereof is coupled to the data line Dm. The second electrode of the first transistor M1 is coupled to one terminal of the storage capacitor Cst. Here, the first electrode of the first transistor M1 is one of a source electrode or a drain electrode, and the second electrode thereof is the other one of the source electrode or the drain electrode. For example, when the first electrode is a source electrode, the second electrode is a drain electrode. The first transistor M1 is turned on when a scan signal is supplied from the scan line Sn to supply a data signal supplied from the data line Dm to the storage capacitor Cst. At this time, the storage capacitor Cst charges a voltage corresponding to the data signal.

The gate electrode of the second transistor M2 is coupled to one terminal of the storage capacitor Cst, and the first electrode thereof is coupled to the first power source ELVDD. The second electrode of the second transistor M2 is coupled to the other terminal of the storage capacitor Cst and the anode electrode of the OLED. The second transistor M2 controls the amount of current supplied from the first power source ELVDD to the second power source ELVSS via the OLED corresponding to the voltage value stored in the storage capacitor Cst.

One terminal of the storage capacitor Cst is coupled to the gate electrode of the second transistor M2 and the other terminal of the storage capacitor Cst is coupled to the anode electrode of the OLED. The storage capacitor Cst charges the voltage corresponding to the data signal.

The conventional pixel 4 supplies a current corresponding to the voltage charged in the storage capacitor Cst to the OLED to display an image with a predetermined brightness. However, a conventional organic light emitting display using the above-described pixel cannot display an image having uniform brightness throughout the display due to deviations in the threshold voltages of the second transistors M2 in different pixels.

Specifically, when the threshold voltages of the second transistors M2 vary between different pixels 4, the pixels 4 generate light with different brightnesses corresponding to the same data signal, and an image with uniform brightness cannot be displayed or is very difficult to display.

WO2006/103797 shows a pixel of an OLED display using several transistors, capacitors and control electrodes in order to compensate deviations in the threshold voltage of the driving transistor.

**SUMMARY OF THE INVENTION**

Accordingly, exemplary embodiments of the present invention provide pixels and an organic light emitting display capable of displaying an image with uniform brightness, independent of the threshold voltages of driving transistors in the pixels. More specifically, a first aspect of the invention provides the pixel as set forth in claim 1. Preferred embodiments of the pixel are subject of the dependent claims 2 through 5. A second aspect of the invention provides the organic light emitting display of claim 6. Preferred embodiments of the organic light emitting display are subject of the dependent claims 7 through 10.

**BRIEF DESCRIPTION OF THE DRAWINGS**

The accompanying drawings, together with the specification, illustrate exemplary embodiments of the present invention, and, together with the description, serve to explain the principles of the present invention.
FIG. 1 is a circuit diagram illustrating a pixel of a conventional organic light emitting display;
FIG. 2 is a schematic view illustrating an organic light emitting display according to an embodiment of the present invention;
FIG. 3 is a circuit diagram illustrating an embodiment of a pixel of FIG. 2; and
FIG. 4 illustrates waveforms describing a method of driving the pixel of FIG. 3.

**DETAILED DESCRIPTION**

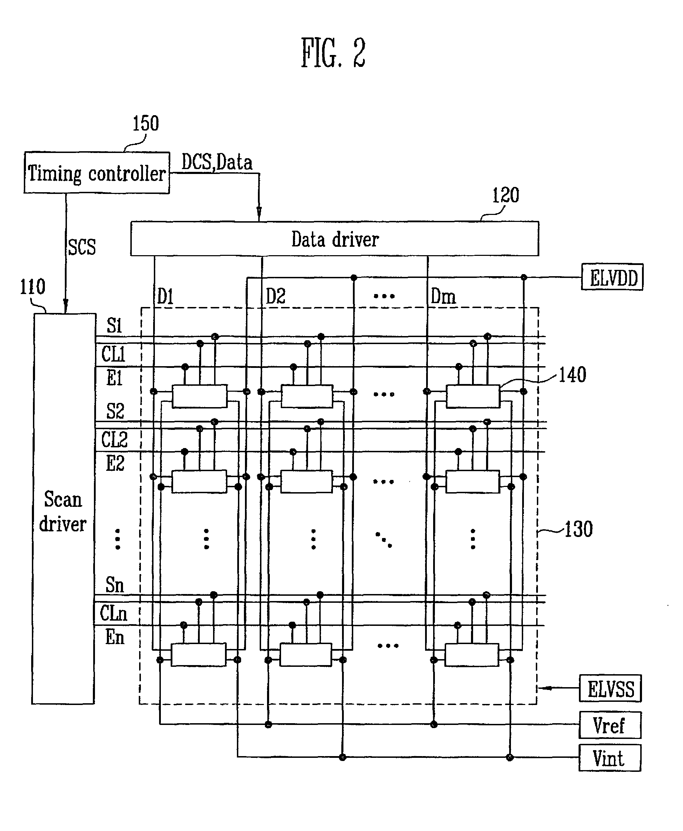

Hereinafter, certain exemplary embodiments according to the present invention will be described with reference to the accompanying drawings. Here, when a first element is described as being coupled to a second element, the first element may be directly coupled to the second element, or may be indirectly coupled to the second element via one or more additional elements. Further, some of the elements that are not essential to the complete understanding of the invention are omitted for clarity. Also, like reference numerals refer to like elements throughout.
Hereinafter, exemplary embodiments by which those skilled in the art can easily perform the present invention will be described in detail with reference to the accompanying drawings, specifically, FIGS. 2 to 4.
FIG. 2 is a schematic view illustrating an organic light emitting display according to an embodiment of the present invention.
Referring to FIG. 2, an organic light emitting display according to an embodiment of the present invention includes pixels 140 coupled to scan lines S1 to Sn, control lines CL1 to CLn, emission control lines E1 to En, and data lines D1 to Dm, a scan driver 110 for driving the scan lines S1 to Sn, the emission control lines E1 to En, and the control lines CL1 to CLn, a data driver 120 for driving the data lines D1 to Dm, and a timing controller 150 for controlling the scan driver 110 and the data driver 120.
The scan driver 110 receives a scan driving control signal SCS from the timing controller 150. The scan driver 110 generates scan signals and sequentially supplies the generated scan signals to the scan lines S1 to Sn. In addition, the scan driver 110 generates control signals and sequentially supplies the generated control signals to the control lines CL1 to CLn. Here, the control signal supplied to an ith (i is a natural number) control line CLi is concurrently supplied with the scan signal supplied to the ith scan line Si, and is supplied for a longer duration than the scan signal. For example, the control signal supplied to the ith control line CLi can be supplied to overlap with the scan signals supplied to at least two scan lines (e.g., Si, Si+1, ....).
The scan driver 110 generates the emission control signals and sequentially supplies the generated emission control signals to the emission control lines E1 to En. Here, the emission control signal supplied to the ith emission control line Ei is supplied to overlap with the control signal supplied to the ith control line CLi.
According to the embodiment of the present invention, the scan signals and the control signals are set to have a voltage by which the transistors included in the pixels 140 can be turned on, and the emission control signals are set to have a voltage by which the transistors included in the pixels 140 can be turned off. For example, the scan signals and the control signals can be set to have a high voltage, while the emission control signals can be set to have a low voltage.
The data driver 120 receives a data driving control signal DCS from the timing controller 150. The data driver 120 supplies data signals to the data lines D1 to Dm synchronously with the scan signals.
The timing controller 150 generates the data driving control signal DCS and the scan driving control signal SCS corresponding to synchronization signals supplied from the outside. The data driving control signal DCS is supplied to the data driver 120 and the scan driving control signal SCS is supplied to the scan driver 110. The timing controller 150 supplies the data Data from the outside to the data driver 120.
A display region 130 receives a first power source ELVDD, a second power source ELVSS, a reference power source Vref, and an initial power source Vint from the outside, and supplies the first power source ELVDD, the second power source ELVSS, the reference power source Vref, and the initial power source Vint to the pixels 140. The pixels 140 generate light corresponding to the data signals.
Here, the voltage Vdata corresponding to the data signals, the voltage of the first power source ELVDD, the voltage of the reference power source Vref, and the voltage of the initial power source Vint are set corresponding to Equation 1.

## Equation 1

$$ELVDD > Vref \geq Vdata > Vint$$

Referring to Equation 1, the reference power source Vref is set to have a voltage equal to or higher than the voltage Vdata of the data signals. The initial power source Vint is set to have a voltage lower than the voltage Vdata of the data signals. More specifically, the initial power source Vint is set to have a voltage lower than a voltage obtained by subtracting the threshold voltage of the driving transistor from the voltage Vdata of the data signals. The first power source ELVDD is set to have a voltage higher than the voltage of the reference power source Vref.

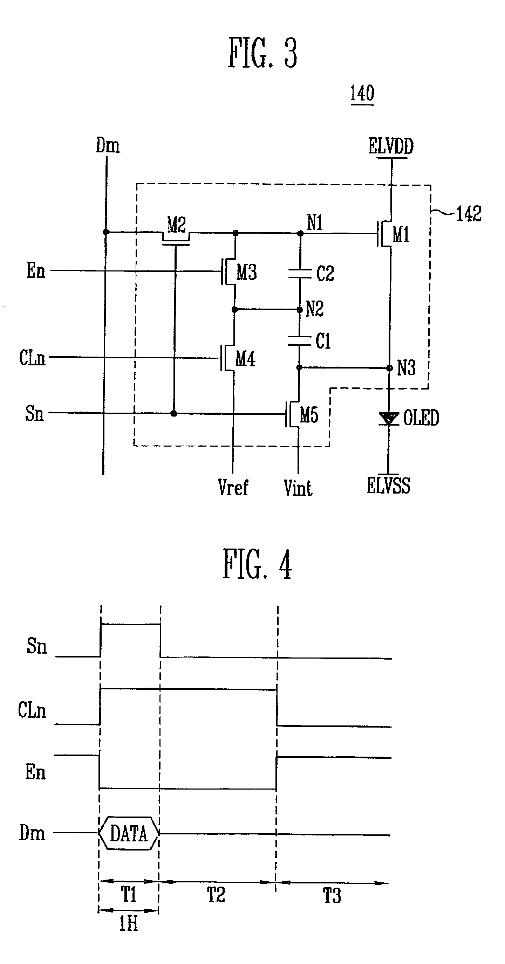

FIG. 3 is a circuit diagram illustrating a pixel according to an embodiment of the present invention. For convenience, in FIG. 3, a pixel coupled to an nth scan line Sn and an mth data line Dm is illustrated.

Referring to FIG. 3, the pixel 140 according to the embodiment of the present invention includes an OLED, and a pixel circuit 142 coupled to a data line Dm, a scan line Sn, an emission control line En, and a control line CLn, to control the OLED.

The anode electrode of the OLED is coupled to the pixel circuit 142 and the cathode electrode of the OLED is coupled to a second power source ELVSS. The OLED generates light with a brightness (e.g., a predetermined brightness) corresponding to a current supplied from the pixel circuit 142.

The pixel circuit 142 charges the voltage corresponding to a data signal during a period where a scan signal (e.g., a high scan signal) is supplied to the scan line Sn. Then, the pixel circuit 142 charges the voltage corresponding to the threshold voltage of a first transistor M1 during a period where the supply of the scan signal to the scan line Sn is stopped, and the supply of a control signal to the control line CLn is continued or maintained. Then, the pixel circuit 142 supplies the current corresponding to the charged voltages to the OLED. The pixel circuit 142 includes first to fifth transistors M1 to M5, a first capacitor C1, and a second capacitor C2.

A gate electrode of the first transistor M1 (a driving transistor) is coupled to a first node N1, and a first electrode of the first transistor M1 is coupled to the first power source ELVDD. A second electrode of the first transistor M1 is coupled to the anode electrode of the OLED at a third node N3. The first transistor M1 controls an amount of current supplied to the OLED in response to a voltage applied to the first node N1.

A gate electrode of the second transistor M2 is coupled to the scan line Sn, and a first electrode of the second transistor M2 is coupled to the data line Dm. A second electrode of the second transistor M2 is coupled to the first node N1. The second transistor M2 is turned on when a scan signal (e.g., a high scan signal) is supplied to the scan line Sn to electrically couple the data line Dm to the first node N1.

A gate electrode of the third transistor M3 is coupled to the emission control line En, and a second electrode of the third transistor M3 is coupled to the first node N1 (i.e., the gate electrode of the first transistor M1). A first electrode of the third transistor M3 is coupled to a second node N2. The third transistor M3 is turned off when an emission control signal (e.g., a low emission control signal) is supplied to the emission control line En, and is turned on when the emission control signal is not supplied, to electrically couple the first node N1 and the second node N2.

A gate electrode of the fourth transistor M4 is coupled to the control line CLn, and a second electrode of the fourth transistor M4 is coupled to the second node N2. A first electrode of the fourth transistor M4 is coupled to the reference power source Vref. The fourth transistor M4 is turned on when a control signal (e.g., a high control signal) is supplied to the control line CLn, to supply the voltage of the reference power source Vref to the second node N2.

A gate electrode of the fifth transistor M5 is coupled to the scan line Sn and a first electrode of the fifth transistor M5 is coupled to the third node N3. A second electrode of the fifth transistor M5 is coupled to the initial power source Vint. The fifth transistor M5 is turned on when the scan signal is supplied to the scan line Sn, to supply the initial power source Vint to the third node N3.

The first capacitor C1 and the second capacitor C2 are coupled in series between the third node N3 and the first node N1. The common node between the first capacitor C1 and the second capacitor C2 is coupled to the second node N2, which is also the common node between the third transistor M3 and the fourth transistor M4. Here, the second capacitor C2 and the third transistor M3 are coupled between the first node N1 and the second node N2 in parallel.

FIG. 4 illustrates waveforms for driving the pixel of FIG. 3.

Processes for operating a pixel according to an embodiment of the present invention will be described in detail with reference to FIGS. 3 and 4.

First, a high scan signal, a high control signal, and a low emission control signal are respectively supplied to the scan line Sn, the control line CLn, and the emission control line En in a first period T1.

When the scan signal is supplied to the scan line Sn, the second transistor M2 and the fifth transistor M5 are turned on. When the control signal is supplied to the control line CLn, the fourth transistor M4 is turned on. When the emission control signal is supplied to the emission control line En, the third transistor M3 is turned off.

When the second transistor M2 is turned on, the data signal from the data line Dm is supplied to the first node N1. When the fifth transistor M5 is turned on, the initial power source Vint is supplied to the third node N3. Here, the initial power source Vint is set to have a voltage for the OLED to be turned off. Therefore, light is not generated by the OLED during this time. When the fourth transistor M4 is turned on, the reference power source Vref is supplied to the second node N2.

That is, in the first period T1, the first node N1 is at the voltage Vdata of the data signal, the second node N2 is at the voltage of the reference power source Vref, and the third node N3 is at the voltage of the initial power source Vint. In this case, the second capacitor C2 is charged with a voltage corresponding to a difference between the voltage Vdata of the data signal and the reference power source Vref, and the first capacitor C1 is charged with a voltage corresponding to a difference between the reference power source Vref and the initial power source Vint. In addition, since the current path flowing through the first transistor M1 in the first period T1 flows to the initial power source Vint, the OLED does not emit light.

Then, in a second period T2, the supply of the scan signal to the scan line Sn is stopped (i.e., the scan signal becomes low). When the supply of the scan signal to the scan line Sn is stopped, the second transistor M2 and the fifth transistor M5 are turned off.

When the second transistor M2 is turned off, the first node N1 maintains the voltage supplied during the first period T1 due to the voltage charged in the second capacitor C2. When the fifth transistor M5 is turned off, the voltage of the third node N3 increases to the voltage obtained by subtracting the threshold voltage of the first transistor M1 from the voltage Vdata of the data signal.

To be more specific, in the first period T1, the voltage of the first node N1 is set at the voltage Vdata of the data signal and the voltage of the third node N3 is set at the voltage of the initial power source Vint. Here, the voltage of the initial power source Vint is set at a voltage lower than the voltage obtained by subtracting the threshold voltage of the first transistor M1 from the voltage Vdata of the data signal. Therefore, when the fifth transistor M5 is turned off, the voltage of the third node N3 increases to a voltage obtained by subtracting the threshold voltage of the first transistor M1 from the voltage Vdata of the data signal.

In this case, the voltage of Vref - Vdata is charged in the second capacitor C2 and the voltage of Vref - Vdata + Vth (M1) is charged in the first capacitor C1.

Then, in a third period T3, the supply of the control signal to the control line CLn is stopped (i.e., the control signal becomes low), and the supply of the emission control signal to the emission control line En is stopped (i.e., the emission control signal becomes high). When the supply of the control signal to the control line CLn is stopped, the fourth transistor M4 is turned off. When the supply of the emission control signal to the emission control line En is stopped, the third transistor M3 is turned on.

When the third transistor M3 is turned on, the first node N1 and the second node N2 are electrically coupled to each other. In this case, a voltage difference between the ends of the second capacitor C2 becomes 0, and the voltage charged in the first capacitor C1 becomes the voltage Vgs (M1) between the gate electrode and the source electrode of the first transistor M1. That is, the voltage between the gate electrode and the source electrode of the first transistor M1 is set corresponding to Equation 2.

## Equation 2

$$Vgs(M1) = Vref - Vdata + Vth(M1)$$

The amount of current that flows to the OLED corresponding to the voltage of Vgs of the first transistor M1 is therefore set corresponding to Equation 3.

## Equation 3

$$Ioled = \beta(Vgs(M1) - Vth(M1))^2 = \beta\{(Vref - Vdata + Vth(M1)) - Vth(M1)\}^2 = \beta(Vref - Vdata)^2$$

Referring to Equation 3, the current that flows to the OLED is determined by a voltage difference between the voltage of the reference power source Vref and the voltage Vdata of the data signal. Here, since the reference power source Vref has a fixed voltage, the current that flows to the OLED is determined by the voltage Vdata of the data signal.

Therefore, according to an embodiment of the present invention, corresponding to Equation 3, an image with uniform brightness can be displayed independent of deviations in the threshold voltages of the first transistors M1 in different pixels of a display.

Furthermore, in FIG. 3, the transistors are NMOS transistors. However, the present invention is not limited to the above described embodiment. For example, the transistors can be PMOS transistors. In this case, the polarities of the supplied waveforms illustrated in FIG. 4 would be inverted. However, the processes for operating the pixel would be substantially similar.

**Claims**

1. A pixel, comprising:

   a first transistor (M1) having a first electrode connected to a first power source (ELVDD) and a gate electrode connected to a first node (N1);
   an organic light emitting diode (OLED) having an anode electrode coupled to a second electrode of the first transistor (M1) and a cathode electrode coupled to a second power source (ELVSS);
   a second transistor (M2) having a first electrode connected to a data line, a second electrode connected to the first node (N1), and a gate electrode connected to a scan line (Sn);
   a third transistor (M3) having a first electrode connected to a second node (N2), a second electrode connected to the first node (N1), and a gate electrode connected to an emission control line (En);
   a fourth transistor (M4) having a first electrode connected to a reference power source (Vref), a second electrode connected to the second node (N2), and a gate electrode connected to a control line (CLn);
   a fifth transistor (M5) having a first electrode connected to the anode electrode of the organic light emitting diode (OLED), a second electrode connected to an initial power source (Vint), and a gate electrode connected to the scan line (Sn);
   a first capacitor (C1) connected between the anode electrode of the organic light emitting diode (OLED) and the second node (N2); and
   a second capacitor (C2) connected between the first node (N1) and the second node (N2).

2. The pixel as claimed in claim 1, wherein the reference power source (Vref) has a voltage equal to or higher than a voltage of the data signal.

3. The pixel as claimed in one of the claims 1 or 2, wherein the initial power source (Vint) has a voltage lower than the voltage of the data signal.

4. The pixel as claimed in claim 3, wherein the voltage of the initial power source (Vint) is lower than a voltage obtained by subtracting a threshold voltage of the first transistor (M1) from the voltage of the data signal.

5. The pixel as claimed in one of the preceding claims, wherein the first power source (ELVDD) has a voltage higher than the voltage of the reference power source (Vref).

6. The pixel as claimed in one of the preceding claims, wherein all of the first transistor (M1), the second transistor (M2), the third transistor (M3), the fourth transistor (M4), and the fifth transistor (M5) are transistors of the same polarity type.

7. The pixel of claim 6, wherein all of the first transistor (M1), the second transistor (M2), the third transistor (M3), the fourth transistor (M4), and the fifth transistor (M5) are NMOS transistors.

8. An organic light emitting display, comprising:

   a scan driver (110) adapted to sequentially supply a scan signal to a plurality of scan lines (S1...Sn), to sequentially supply an emission control signal to a plurality of emission control lines (E1...En), and to sequentially supply a control signal to a plurality of control lines (CL1...CLn), the scan lines (S1...Sn), emission control lines (E1...En), and control lines (CL1...CLn) extending in a first direction;
   a data driver (120) adapted to supply a data signal to a plurality of data lines (D1...Dm) extending in a second direction crossing the first direction; and
   a plurality of pixels (140) arranged at crossing regions of the scan lines (S1...Sn), the emission control lines (E1...En), and the control lines (CL1...CLn) with the data lines (D1...Dm), wherein each pixel (140) is a pixel according to one of the preceding claims.

9. The organic light emitting display as claimed in claim 8, wherein the scan driver (110) is configured to supply the scan signal to an ith scan line (Si) when supplying the control signal to an ith control line (CLi).

10. The organic light emitting display as claimed in one of the claims 8 or 9, wherein the scan driver (110) is adapted to provide the control signal for a longer time period than the scan signal.

11. The organic light emitting display as claimed in one of the claims 8 through 10, wherein the scan driver (110) is configured to supply the emission control signal to an ith emission control line when supplying the control signal to an ith control line.

12. The organic light emitting display as claimed in one of the claims 8 through 11, wherein the data driver (120) is configured to provide the data signal for a row of pixels corresponding to an ith scan line (Si) concurrently with the scan driver (110) supplying the scan signal to the ith scan line (Si).

**Patentansprüche**

1. Pixel, umfassend
einen ersten Transistor (M1) mit einer ersten Elektrode, die mit einer ersten Stromquelle (ELVDD) verbunden ist, und einer Gateelektrode, die mit einem ersten Knoten (N1) verbunden ist;
eine organische lichtemittierende Diode (OLED) mit einer Anodenelektrode, die mit einer zweiten Elektrode des ersten Transistors (M1) gekoppelt ist, und einer Kathodenelektrode, die mit einer zweiten Stromquelle (ELVSS) gekoppelt ist;
einen zweiten Transistor (M2) mit einer ersten Elektrode, die mit einer Datenleitung verbunden ist, einer zweiten Elektrode, die mit dem ersten Knoten (N1) verbunden ist, und einer Gateelektrode, die mit einer Abtastzeile (Sn) verbunden ist;
einen dritten Transistor (M3) mit einer ersten Elektrode, die mit einem zweiten Knoten (N2) verbunden ist, einer zweiten Elektrode, die mit dem ersten Knoten (N1) verbunden ist, und einer Gateelektrode, die mit einer Emissionssteuerleitung (En) verbunden ist;
einen vierten Transistor (M4) mit einer ersten Elektrode, die mit einer Bezugsstromquelle (Vref) verbunden ist, einer zweiten Elektrode, die mit dem zweiten Knoten (N2) verbunden ist, und einer Gatelektrode, die mit einer Steuerleitung (CLn) verbunden ist;
einen fünften Transistor (M5) mit einer ersten Elektrode, die mit der Anodenelektrode der organischen lichtemittierenden Diode (OLED) verbunden ist, einer zweiten Elektrode, die mit einer Anfangsstromquelle (Vint) verbunden ist, und einer Gateelektrode, die mit der Abtastzeile (Sn) verbunden ist;
einen ersten Kondensator (C1), der zwischen die Anodenelektrode der organischen lichtemittierenden Diode (OLED) und den zweiten Knoten (N2) geschaltet ist; und einen zweiten Kondensator (C2), der zwischen den ersten Knoten (N 1) und den zweiten Knoten (N2) geschaltet ist.

2. Pixel nach Anspruch 1, wobei die Bezugsstromquelle (Vref) eine Spannung aufweist, die gleich einer oder höher als eine Spannung des Datensignals ist.

3. Pixel nach einem der Ansprüche 1 oder 2, wobei die Anfangsstromquelle (Vint) eine Spannung aufweist, die niedriger als die Spannung des Datensignals ist.

4. Pixel nach Anspruch 3, wobei die Spannung der Anfangsstromquelle (Vint) niedriger ist als eine Spannung, die durch Subtrahieren einer Schwellenspannung des ersten Transistors (M1) von der Spannung des Datensignals erhalten wird.

5. Pixel nach einem der vorangegangenen Ansprüche, wobei die erste Stromquelle (ELVDD) eine Spannung aufweist, die höher als die Spannung der Bezugsstromquelle (Vref) ist.

6. Pixel nach einem der vorangegangenen Ansprüche, wobei sowohl der erste Transistor (M 1) als auch der zweite Transistor (M2), der dritte Transistor (M3), der vierte Transistor (M4) und der fünfte Transistor (M5) Transistoren vom selben Polaritätstyp sind.

7. Pixel nach Anspruch 6, wobei sowohl der erste Transistor (M1) als auch der zweite Transistor (M2), der dritte Transistor (M3), der vierte Transistor (M4) und der fünfte Transistor (M5) NMOS-Transistoren sind.

8. Organisches Leuchtemissionsdisplay, umfassend:

einen Abtasttreiber (110), der ausgebildet ist, einer Vielzahl von Abtastzeilen (S1...Sn) sequentiell ein Abtastsignal zuzuführen, einer Vielzahl von Emissionssteuerleitungen (E1...En) sequentiell ein Emissionssteuersignal zuzuführen, und einer Vielzahl von Steuerleitungen (CL1...CLn) sequentiell ein Steuersignal zuzuführen, wobei sich die Abtastzeilen (S1...Sn), die Emissionssteuerleitungen (E1...En) und die Steuerleitungen (CL1...CLn) in eine erste Richtung erstrecken;
einen Datentreiber (120), der ausgebildet ist, einer Vielzahl von Datenleitungen (D1...Dm), die sich, die erste Richtung kreuzend, in eine zweite Richtung erstrecken, ein Datensignal zuzuführen; und
eine Vielzahl von Pixeln (140), die an sich mit den Datenleitungen (D1...Dm) kreuzenden Bereichen der Abtastzeilen (S1...Sn), der Emissionssteuerleitungen (E1...En) und der Steuerleitungen (CL1...CLn) angeordnet sind, wobei jedes Pixel (140) ein Pixel nach einem der vorangegangenen Ansprüche ist.

9. Organisches Leuchtemissionsdisplay nach Anspruch 8, wobei der Abtasttreiber (110) ausgebildet ist, das Abtastsignal einer i'ten Abtastzeile (Si) zuzuführen, wenn das Steuersignal einer i'ten Steuerleitung (CLi) zugeführt wird.

10. Organisches Leuchtemissionsdisplay nach einem der Ansprüche 8 oder 9, wobei der Abtasttreiber (110) ausgebildet ist, das Steuersignal für einen längeren Zeitraum bereitzustellen als das Abtastsignal.

11. Organisches Leuchtemissionsdisplay nach einem der Ansprüche 8 bis 10, wobei der Abtasttreiber (110) ausgebildet ist, das Emissionssteuersignal einer i'ten Emissionssteuerleitung zuzuführen, wenn das Steuersignal einer i'ten Steuerleitung zugeführt wird.

12. Organisches Leuchtemissionsdisplay nach einem der Ansprüche 8 bis 11, wobei der Datentreiber (120) ausgebildet ist, das Datensignal für eine Zeile von Pixeln entsprechend einer i'ten Abtastzeile (Si) gleichzeitig mit dem Abtasttreiber (110), der das Abtastsignal der i'ten Abtastzeile zuführt, bereitzustellen.

**Revendications**

1. Pixel, comprenant :

un premier transistor (M1) ayant une première électrode connectée à un premier bloc d'alimentation (ELVDD) et une électrode de grille connectée à un premier noeud (N1) ;
une diode électroluminescente organique (dite OLED) ayant une électrode anodique couplée à une deuxième électrode du premier transistor (M1) et une électrode cathodique couplée à un deuxième bloc d'alimentation (ELVSS) ;
un deuxième transistor (M2) ayant une première électrode connectée à une ligne de données, une deuxième électrode connectée au premier noeud (N1) , et une électrode de grille connectée à une ligne de balayage (Sn) ;
un troisième transistor (M3) ayant une première électrode connectée à un deuxième noeud (N2), une deuxième électrode connectée au premier noeud (N1) et une électrode de grille connectée à une ligne de commande d'émission (En) ;
un quatrième transistor (M4) ayant une première électrode connectée à un bloc d'alimentation de référence (Vref), une deuxième électrode connectée au deuxième noeud (N2) et une électrode de grille connectée à une ligne de commande (CLn) ;
un cinquième transistor (M5) ayant une première électrode connectée à l'électrode anodique de la diode électroluminescente organique (OLED), une deuxième électrode connectée à un bloc d'alimentation initial (Vint) et une électrode de grille connectée à la ligne de balayage (Sn);
un premier condensateur (C1) connecté entre l'électrode anodique de la diode électroluminescente organique (OLED) et le deuxième noeud (N2) ; et
un deuxième condensateur (C2) connecté entre le premier noeud (N1) et le deuxième noeud (N2) .

2. Pixel tel que revendiqué dans la revendication 1, dans lequel le bloc d'alimentation de référence (Vref) a une tension supérieure ou égale à une tension du signal de données.

**3.** Pixel tel que revendiqué dans l'une des revendications 1 et 2, dans lequel le bloc d'alimentation initial (Vint) a une tension inférieure à la tension du signal de données.

**4.** Pixel tel que revendiqué dans la revendication 3, dans lequel la tension du bloc d'alimentation initial (Vint) est inférieure à une tension obtenue en soustrayant une tension de seuil du premier transistor (M1) de la tension du signal de données.

**5.** Pixel tel que revendiqué dans l'une des revendications précédentes, dans lequel le premier bloc d'alimentation (ELVDD) a une tension supérieure à la tension du bloc d'alimentation de référence (Vref).

**6.** Pixel tel que revendiqué dans l'une des revendications précédentes, dans lequel le premier transistor (M1), le deuxième transistor (M2), le troisième transistor (M3), le quatrième transistor (M4) et le cinquième transistor (M5) sont tous des transistors de même type de polarité.

**7.** Pixel de la revendication 6, dans lequel le premier transistor (M1), le deuxième transistor (M2), le troisième transistor (M3), le quatrième transistor (M4) et le cinquième transistor (M5) sont tous des transistors NMOS.

**8.** Dispositif d'affichage électroluminescent organique, comprenant :

un circuit d'attaque (110) de balayage adapté pour fournir de manière consécutive un signal de balayage à une pluralité de lignes de balayage (S1...Sn), pour fournir de manière séquentielle un signal de commande d'émission à une pluralité de lignes de commande d'émission (E1...En), et pour fournir de manière séquentielle un signal de commande à une pluralité de lignes de commande (CL1...CLn), de lignes de balayage (S1...Sn), de lignes de commande d'émission (E1...En) et de lignes de commande (CL1...CLn) s'étendant dans une première direction ;
un circuit d'attaque (120) de données adapté pour fournir un signal de données à une pluralité de lignes de données (D1...Dm) s'étendant dans une deuxième direction croisant la première direction ; et
une pluralité de pixels (140) agencés au niveau des régions de croisement des lignes de balayage (S1...Sn), des lignes de commande d'émission (E1...En) et des lignes de commande (CL1...CLn) avec les lignes de données (D1...Dm) , où chaque pixel (140) est un pixel selon l'une des revendications précédentes.

**9.** Dispositif d'affichage électroluminescent organique tel que revendiqué dans la revendication 8, dans lequel le circuit d'attaque (110) de balayage est configuré pour fournir le signal de balayage à une ième ligne de balayage (Si) tout en fournissant le signal de commande à une ième ligne de commande (CLi).

**10.** Dispositif d'affichage électroluminescent organique tel que revendiqué dans l'une des revendications 8 et 9, dans lequel le circuit d'attaque (110) de balayage est adapté pour fournir le signal de commande pendant une durée plus longue que le signal de balayage.

**11.** Dispositif d'affichage électroluminescent organique tel que revendiqué dans l'une des revendications 8 à 10, dans lequel le circuit d'attaque (110) de balayage est configuré pour fournir le signal de commande d'émission à une ième ligne de commande d'émission tout en fournissant le signal de commande à une ième ligne de commande.

**12.** Dispositif d'affichage électroluminescent organique tel que revendiqué dans l'une des revendications 8 à 11, dans lequel le circuit d'attaque (120) de données est configuré pour fournir le signal de données à une rangée de pixels correspondant à une ième ligne de balayage (Si) simultanément avec le circuit d'attaque (110) de balayage fournissant le signal de balayage à la ième ligne de balayage (Si).

# FIG. 1

# FIG. 2

# FIG. 3

<u>140</u>

# FIG. 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2006103797 A